# EUROPÄISCHE PATENTANMELDUNG

(11) **EP 1 672 861 A2**
(43) Veröffentlichungstag der Anmeldung: **21.06.2006**
(21) Anmeldenummer: 05027406.7
(22) Anmeldetag: 14.12.2005
(51) Int. Cl.: H04L 27/36

(54) **Polarmodulator und entsprechendes Verfahren zur Modulation eines Signals**

(30) Priorität: 14.12.2004 DE 102004060177
(71) Anmelder: Infineon Technologies AG, 81669 München (DE)
(72) Erfinder: Li Puma, Giuseppe, 44791 Bochum (DE)
(74) Vertreter: Epping - Hermann - Fischer

(57) **Zusammenfassung**

In einem Polarmodulator wird in einem Phasenregelkreis (2) aus einem Phasenmodulationssignal ein moduliertes Trägersignal erzeugt. Dieses wird über einen begrenzenden Verstärker (30) in ein Rechtecksignal gewandelt und einem Verstärker (4) zugeführt. Gleichzeitig wird ein Amplitudenmodulationssignal an einem Eingang (11) an einen Stelleingang (31) einer regelbaren Stromquelle (3) angeschlossen. Die regelbare Stromquelle ist zur Abgabe eines Versorgungsstromes an einem Stromausgang (32) abhängig von dem Amplitudenmodulationssignal am Stelleingang (31) ausgebildet. Der Stromausgang (32) der regelbaren Stromquelle (3) ist an einen Versorgungseingang (43) des Verstärkers (4) angeschlossen. Dadurch wird der Versorgungsstrom des Verstärkers (4) gemäß der zu übertragenden Amplitudeninformation moduliert. Die Verarbeitung der Amplitudeninformation innerhalb der Stromdomäne erlaubt eine Realisierung des erfindungsgemäßen Polarmodulators in CMOS-Technologie als integrierte Schaltung.

## Beschreibung

Die Erfindung betrifft einen Polarmodulator sowie ein Verfahren zur Modulation eines Signals.

In modernen Kommunikationssystemen werden die zu übertragenden Informationen sowohl in der Phase als auch in der Amplitude eines Signals kodiert. Dadurch ist es möglich, im Gegensatz zu einer reinen Amplituden- beziehungsweise Phasenmodulation deutlich größere Datenübertragungsraten zu erreichen. Beispiele für derartige Modulationsarten sind die PSK-Modulationen (Phase-Shift-Keying). Dazu gehören unter anderem die π/4-DQPSK-, 8-DPSK- oder 8-PSK-Modulation. Auch Quadraturamplitudenmodulationen (QAM) kodieren die zu übertragenden Informationen sowohl in der Amplitude als auch in der Phase. Im Gegensatz zu den analogen Amplituden- oder Frequenzmodulationen werden die genannten Modulationen als digitale Modulationsarten bezeichnet.

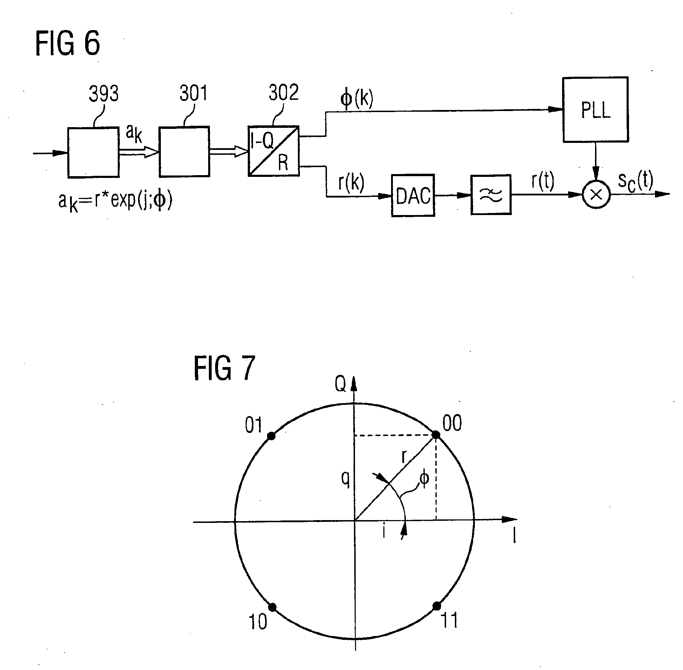

Figur 7 zeigt ein sogenanntes Konstellationsdiagramm für eine QPSK-Modulation. Die Abszisse stellt dabei eine erste Komponente dar, die als reelle Komponente I bezeichnet wird. Die Ordinate bildet die zweite, die Quadraturkomponente Q. Die zu übertragenden Informationen werden abhängig von ihrem Inhalt in einem der dargestellten Punkte durch ein Wertepaar i, q kodiert. Ein solches Wertepaar i, q wird als Symbol bezeichnet. Im dargestellten Ausführungsbeispiel kodiert ein solches Symbol bei der verwendeten QPSK-Modulationsart insgesamt zwei Bits Dateninhalt, nämlich die Bits 00, 01, 10 oder 11. Je nach den zu übertragenden Informationen ändern sich die Amplituden und die Phase der I- und Q-Werte über die Zeit. Dadurch wird auch die Amplitude des Gesamtsignals verändert. Man spricht folglich bei einer QPSK-Modulation von einer Modulationsart mit einer nichtkonstanten Einhüllenden (Non-Constant-Envelope-Modulation). Die QPSK-Modulationsart wird beispielsweise für den Mobilfunkstandart WCDMA/UMTS verwendet.

Neben der Darstellung eines Symbols durch ein Wertepaar i, q ist es möglich, das gleiche Symbol in seiner Phase φ und seiner Amplitude r anzugeben. Im Ausführungsbeispiel der Figur 7 ist das Symbol, das den Dateninhalt 00 repräsentiert entsprechend dargestellt. Beide Darstellungen in IQ-Schreibweise beziehungsweise rφ-Schreibweise sind gleichbedeutend.

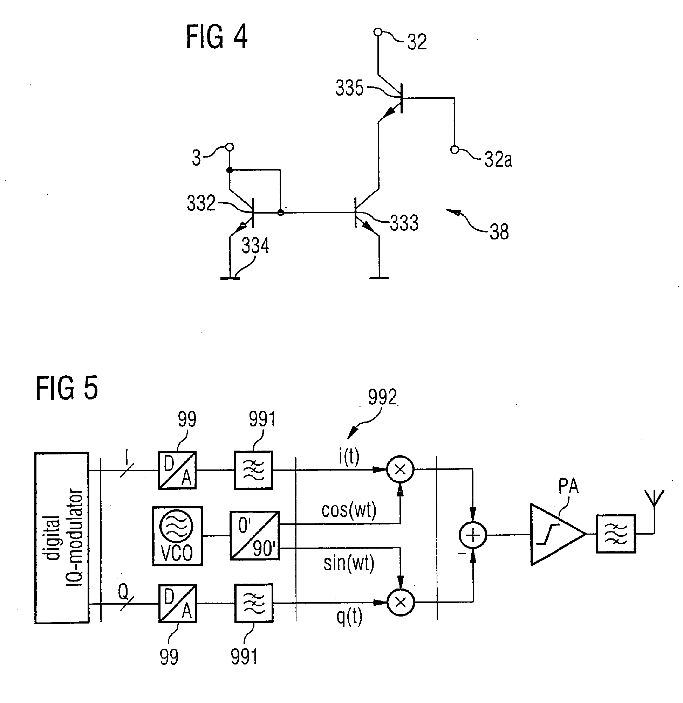

Zur Übertragung von modulierten Signalen lassen sich neben I/Q-Modulatoren auch Polarmodulatoren verwenden. Während I/Q-Modulatoren für eine Modulation eines Signals i, q-Wertepaare verarbeiten, modulieren Polarmodulatoren die Phase φ und die Amplitude r. Eine Ausführung für einen bekannten I/Q-Modulator ist in Figur 5 zu sehen. Darin werden die Komponenten I, Q als digitale Signale jeweils einem Digital/Analogwandler 99 zugeführt, der sie in analoge Komponenten wandelt und sie über einen Tiefpassfilter 991 den Eingängen zweier Mischer 992 zuführt. Als Lokaloszillatorsignal werden den beiden Mischern Signale zugeführt, die zueinander einen Phasenversatz von 90 Grad aufweisen. Nach der Frequenzumsetzung durch die beiden Mischer erfolgt eine Addition der beiden Signale und eine Verstärkung in einem Leistungsverstärker PA.

Ein Beispiel für einen bekannten Polarmodulator zeigt Figur 6. Die zu übertragenden Informationen liegen als digitale Daten vor aₖ und werden in einer Koderschaltung 993 in die Amplitudeninformation r und die Phaseninformation φ aufbereitet. Diese werden einer Pulsformerschaltung 901 zugeführt und dort aufbereitet. Die aufbereiteten Daten werden dann in der Schaltung 902 in ihren Phasenwert φ (k) sowie in einen Amplitudenwert r(k) umgewandelt. Die Phaseninformation φ (k) wird einem Phasenregelkreis PLL zugeführt. Sie wird dazu verwendet, das Ausgangssignal des Phasenregelkreises entsprechend der in der Phase kodierten Information zu modulieren. Am Ausgang des Regelkreises PLL liegt somit ein zeitlich veränderliches, phasenmoduliertes Ausgangssignal φ(t) vor. Gleichzeitig wird die Amplitudeninformation r(k) an einen Digital/Analogwandler DAC angelegt, der die digitale Amplitudeninformation r(k) in ein zeitliches analoges Signal r(t) wandelt. Das analoge Amplitudenmodulationssignal r(t) wird über einen Tiefpassfilter einem Mischer zugeführt. In diesem wird das phasenmodulierte Signal mit dem Amplitudenmodulationssignal zusammengeführt.

Problematisch bei diesen Lösungen sind die Anforderungen an die letzte Mischerstufe. Diese sollte ein ausreichend hohes lineares Übertragungsverhalten aufweisen, um den in vielen Mobilfunkstandards geforderten großen Amplitudenbereich einzuhalten. Bei einem nichtlinearen Übertragungsverhalten des Mischers können daher Amplituden- oder Phasenverzerrungen auftreten, die von dem Amplitudenmodulationssignal r(t) abhängig sind. Man bezeichnet derartige Verzerrungen als AM/AM- oder AM/PM-Verzerrung. Die Verzerrung erzeugt Datenfehler und das Frequenzspektrum des abgegebenen Signals ändert sich dadurch. Zusätzlich benötigen Mischer einen großen Strom, um die Linearitätsanforderungen zu genügen.

Die in Figur 6 dargestellte Ausführungsform führt zu einem hohen Platzbedarf für den Mischer. Darüber hinaus lässt sich ein derartiger Polarmodulator nicht in neuartigen CMOS-Technologien mit niedrigen Versorgungsspannungen im Bereich von 1,5 V bis 2,5 V implementieren.

Aufgabe der vorliegenden Erfindung ist es, einen Polarmodulator vorzusehen, der für niedrige Versorgungsspannungen geeignet und platzsparend bevorzugt als integrierte Schaltung in einem Halbleiterkörper realisierbar ist. Eine weitere Aufgabe der Erfindung ist es ein Verfahren zur Modulation eines Signals anzugeben, das mit einem geringen Stromverbrauch zu realisieren ist.

Diese Aufgaben werden mit den Gegenständen der nebengeordneten Patentansprüche 1 und 16 gelöst.

Bezüglich der Anordnung wird die Aufgabe gelöst durch einen Polarmodulator, der einen ersten Signaleingang zur Zuführung eines Phasenmodulationssignals sowie einen zweiten Signaleingang zur Zuführung eines Amplitudenmodulationssignals aufweist. Ein Phasenregelkreis mit einem Referenzeingang zur Zuführung eines Referenzsignals ist mit einem Stelleingang mit dem ersten Signaleingang gekoppelt. Der Regelkreis ist ausgebildet zur Abgabe eines Hochfrequenzsignals mit einer Frequenz, die aus dem Referenzsignal und dem Phasenmodulationssignal am Stelleingang des Regelkreises abgeleitet ist. Weiterhin ist eine regelbare Stromquelle vorgesehen, die mit einem Regeleingang an den zweiten Signaleingang angeschlossen ist. Die Stromquelle ist zur Abgabe eines von dem Amplitudenmodulationssignal am Regeleingang abhängigen Stroms an einen Ausgang ausgebildet. Ein Verstärker ist mit einem Signaleingang zur Zuführung eines zu verstärkenden Signals an einen Ausgang des Phasenregelkreises angeschlossen. Ein Signalausgang des Verstärkers bildet einen Ausgang des Polarmodulators. Weiterhin umfasst der Verstärker einen Versorgungsanschluss zur Zuführung eines Versorgungsstroms zum Betreiben des Verstärkers. Dieser ist mit dem Ausgang der regelbaren Stromquelle verbunden.

Die Ausgestaltung erlaubt es, den erfindungsgemäßen Polarmodulator in einem Halbleiterkörper, insbesondere in CMOS-Technologie zu realisieren. Bevorzugt erfolgt in dem Polarmodulator eine Amplitudenmodulation über eine Modulation des Versorgungsstroms des dem Phasenregelkreis nachgeschalteten Verstärkers. Dadurch lässt sich ein besonders hoher dynamischer Bereich erreichen, da das erreichbare Signal/Rauschverhältnis bei einer Modulation des Versorgungsstroms deutlich größer ist, als bei einer vergleichbaren Modulation eines Spannungssignals. Insbesondere ist es so möglich den erfindungsgemäßen Modulator in CMOS-Technologie in einem integrierten Halbleiterkörper zu realisieren.

In einer bevorzugten Weiterbildung der Erfindung ist zwischen dem Ausgang des Phasenregelkreises und dem Signaleingang des Verstärkers eine Verstärkerschaltung vorgesehen, die ein begrenzendes Verstärkungsverhalten aufweist. In einer zweckmä-βigen Ausgestaltung ist der Verstärker als Differenzverstärker ausgeführt und enthält einen ersten Transistor sowie einen zweiten Transistor. Die Steueranschlüsse der beiden Transistoren bilden den Signaleingang des Verstärkers. Jeweils ein erster Anschluss des ersten und zweiten Transistors ist in einem Knoten miteinander verbunden, der den Versorgungsanschluss zur Stromversorgung bildet. Bevorzugt lässt sich dieser Verstärker in einem schaltenden Betriebsmodus betreiben. Dies wird durch einen eventuell vorgeschalteten Verstärker mit begrenzendem Verstärkungsverhalten erreicht.

In einer anderen geeigneten Weiterbildung enthält der Verstärker einen transformatorischen Übertrager, der zur Transformation eines Gegentaktausgangssignals in ein Eintakt/Ausgangssignals ausgeführt ist. An den transformatorischen Übertrager ist bevorzugt ein Anpassnetzwerk zur Impedanztransformation angeschlossen.

In einer anderen Weiterbildung der Erfindung enthält der Phasenregelkreis einen Frequenzteiler in einem Rückführungspfad, der ausgebildet ist, ein eingangsseitig anliegendes Signal in seiner Frequenz um einen einstellbaren Teilerfaktor zu teilen. In einer zweckmäßigen Weiterbildung ist im Einstelleingang des Frequenzteilers ein Sigma-Delta-Frequenzteiler vorgeschaltet. Dieser ist eingangsseitig mit dem ersten Signaleingang gekoppelt. Durch den vorgeschalteten Sigma-Delta-Modulator sind unterschiedliche Frequenzteilerverhältnisse und im besonderen gebrochene Frequenzteilerverhältnisse einstellbar. Dadurch kann sehr effizient die Phase des Ausgangssignals des Phasenregelkreises moduliert werden.

In einer anderen Weiterbildung der Erfindung ist der Phasenregelkreis mit einem Zwei-Punkt-Modulator ausgebildet. Dieser zeichnet sich dadurch aus, dass der Einstelleingang sowohl mit einem zusätzlichen Stelleingang des spannungsgesteuerten Oszillators des Phasenregelkreises als auch mit der Frequenzteilerschaltung gekoppelt ist. Somit wird bei einem Zwei-Punkt-Modulator sowohl das Frequenzteilerverhältnis neu eingestellt, als auch der spannungsgesteuerte Oszillator des Regelkreises direkt moduliert.

Wieder in einer anderen Weiterbildung der Erfindung enthält die regelbare Stromquelle einen Stromspiegel. Ein Ausgang des Stromspiegeltransistor der regelbaren Stromquelle bildet den Ausgang der Stromquelle. Einem ersten Transistor ist ein von dem Amplitudenmodulationssignal abgeleiteter Referenzstrom zuführbar. In einer Ausführung der Erfindung enthält die regelbare Stromquelle einen Digital/Analogwandler dessen Eingang an den Regeleingang angeschlossen ist und der eingangsseitig ein zugeführtes wertdiskretes Signal in ein Stromsignal an einem Ausgang wandelt. In einer anderen zweckmäßigen Ausgestaltung ist zwischen dem Digital/Analogwandler und dem Ausgang der regelbaren Stromquelle ein Tiefpassfilter geschaltet. Dieses unterdrückt höherwertige Frequenzanteile, die während eines Wandelvorgangs erzeugt werden. In einer anderen Weiterbildung der Erfindung enthält die regelbare Stromquelle eine Vielzahl an Teilstromquellen, deren Ausgänge über jeweils eine durch ein Signal am Regeleingang steuerbaren Schaltvorrichtung auf den Ausgang der Stromquelle schaltbar sind. Die Vielzahl an Teilstromquellen sind bevorzugt mit Stromspiegeln ausgeführt.

Ein Verfahren zur Modulation eines Signals enthält die Schritte:
- Bereitstellen eines Phasenregelkreises mit einem einstellbaren Frequenzteilerverhältnis in einem Rückführungspfad des Phasenregelkreises;
- Bereitstellen eines Verstärkers und Koppeln des Verstärkers mit dem Phasenregelkreis;
- Bereitstellen einer Phaseninformation und einer Amplitudeninformation für eine Signalmodulation;
- Zuführen der Phaseninformation an den Phasenregelkreis und Einstellen des Frequenzteilerverhältnisses in Abhängigkeit der Phaseninformation;
- Erzeugen eines phasenmodulierten Signals in Abhängigkeit des eingestellten Frequenzteilerverhältnisses;
- Erzeugen eines Stromsignals aus der Amplitudeninformation;
- und Zuführen des phasenmodulierten Signals an den Verstärker bei gleichzeitigem Versorgen des Verstärkers mit einem von dem Stromsignal abgeleiteten Versorgungsstrom.

Erfindungsgemäß wird ein Signal sowohl in der Phase als auch in der Amplitude moduliert, wobei eine Amplitudenmodulation über eine Modulation eines Versorgungsstroms eines Verstärkers erfolgt. Die Modulation eines Versorgungsstroms ermöglicht es, die Versorgungsspannung zu reduzieren um das Verfahren bevorzugt in integrierten Schaltungen in einem Halbleiterkörper einzusetzen. Gleichzeitig wird jedoch ein ausreichend gutes Signal/Rauschverhältnis des Versorgungsstroms gewährleistet. Ebenso vorteilhaft können durch die Amplitudenmodulation des Versorgungsstroms zusätzliche Funktionen beispielsweise ein "Power ramping" oder eine Einstellung einer maximalen Ausgangsleistung besonders einfach und kostengünstig erreicht werden. Eine reine Frequenzmodulation ist durch Zuführung eines konstanten Amplitudenmodulationssignals ebenfalls erreichbar.

Im Folgenden wird die Erfindung anhand von Ausführungsbeispielen unter Bezugnahme auf die Zeichnungen im Detail erläutert.

Es zeigen:
Figur 1 ein erstes Ausführungsbeispiel des erfindungsgemäßen Polarmodulators,
Figur 2 einen Ausschnitt des erfindungsgemäßen Polarmodulators mit einem Ausführungsbeispiel eines Verstärkers,
Figur 3 einen Digital/Analogwandler zur Bereitstellung eines modulierten Stromsignals,
Figur 4 einen Stromspiegel, wie er in der regelbaren Stromquelle einsetzbar ist,
Figur 5 einen bekannten I/Q-Modulator,
Figur 6 einen bekannten Polarmodulator,
Figur 7 ein Konstellationsdiagramm zur Darstellung von zu übertragenden Informationen.

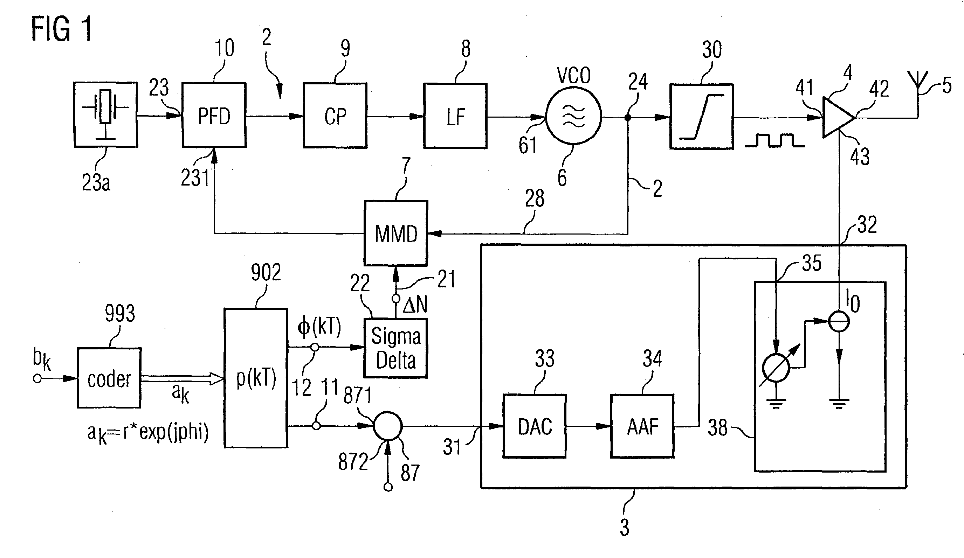

Figur 1 zeigt eine Ausführungsform des erfindungsgemäßen Polarmodulators, der in einem Halbleiterkörper in CMOS-Technologie realisiert ist. Als Halbleitermaterial bietet sich beispielsweise Silizium, Galliumarsenid oder Siliziumgermanium (SiGe) an. Darin wird der erfindungsgemäße Polarmodulator in CMOS-Technologie als integrierte Schaltung ausgeführt. Die zunehmende Verkleinerung macht es erforderlich, auch die Versorgungsspannung für die Schaltelemente zu reduzieren. Ebenso werden Steuerspannungen reduziert. Dabei wird jedoch das Signal/Rauschverhältnis der Signale verschlechtert. Durch die Reduktion können die Linearitätsanforderungen für eventuell vorhandene Mischer im Polarmodulator nicht mehr eingehalten werden.

Folglich verwendet der erfindungsgemäße Polarmodulator keinen Frequenzmischer mehr, sondern einen Verstärker, dessen Versorgungsstrom moduliert wird, um eine Amplitudenmodulation zu erreichen. Die erfindungsgemäße Endstufe könnte daher auch als "Leistungsmischer" bezeichnet werden, der den Amplitudenanteil auf das phasenmodulierte Trägersignal umsetzt.

Der Polarmodulator weist einen ersten Eingang 12 auf, der zur Zuführung eines Phaseninformationssignals φ (kT) ausgeführt ist. Dieses wird als digitales Signal dem Polarmodulator zugeführt. Darüber hinaus weist er einen zweiten Eingang 11 auf, an dem die Amplitudeninformation in Form eines digitalen Signals r(kT) anliegt.

Der Polarmodulator enthält einen Phasenregelkreis 2. Dieser umfasst einen Phasendetektor 10 mit einem Referenzeingang 23 sowie einen Rückführungseingang 231. Der Referenzeingang 23 ist an einen Referenzsignalgenerator 23a zur Erzeugung eines Signals mit einer Referenzfrequenz angeschlossen. Dies kann beispielsweise ein Quarz mit einer besonders stabilen Resonanzfrequenz sein. Der Phasendetektor 10 vergleicht die Phasen der an den Eingängen 23 und 231 anliegenden Signale und erzeugt daraus ein Steuersignal, das er an eine Ladungspumpe 9 abgibt. Die Ladungspumpe 9 ist über einen Schleifenfilter 8 an einen Steuereingang 61 eines spannungsgesteuerten Oszillators 6 angeschlossen. Das Steuersignal dient zur Einstellung der Frequenz eines Ausgangssignals des spannungsgesteuerten Oszillators 6. Der spannungsgesteuerte Oszillator 6 gibt dieses an seinem Ausgang ab.

Der Ausgang des spannungsgesteuerten Oszillators ist in einem Knoten 24 an einen Rückführungspfad 28 angeschlossen. In diesem ist eine Frequenzteilerschaltung 7 vorgesehen, die ein eingangsseitig anliegendes Signal in der Frequenz um einen einstellbaren Teilerfaktor teilt und das frequenzgeteilte Signal dem Rückführungseingang 231 des Phasendetektors 10 zuführt. Am Stelleingang 21 der Frequenzteilerschaltung 7 lässt sich das Frequenzteilerverhältnis einstellen. Abhängig von einer Änderung des Frequenzteilerverhältnisses wird so die Frequenz des Ausgangssignals des Regelkreises geändert. Somit ist eine Phasen- beziehungsweise eine Frequenzmodulation des Ausgangssignals des Phasenregelkreises möglich.

Der Stelleingang 21 des Frequenzteilers 7 ist an einen Sigma-Delta-Modulator 22 angeschlossen. Dieser ist eingangsseitig mit dem ersten Signaleingang 12 zur Zuführung des Phasenmodulationssignals verbunden. Aus der Phaseninformation, durch das Phasenmodulationssignal φ(kT) dargestellt, erzeugt der Sigma-Delta-Modulator ein Frequenzeinstellverhältnis, das einen ganzzahligen Wert N und einen gebrochenen Teilerwert ΔN umfasst. Das Frequenzeinstellverhältnis führt der Sigma-Delta-Modulator 22 dem Stelleingang 21 und damit dem Frequenzteiler 7 zur Frequenz- beziehungsweise Phasenmodulation des Ausgangssignals im Phasenregelkreis zu.

Der Ausgang des Phasenregelkreises ist an einen limitierenden Verstärker 30 angeschlossen, der ein im wesentlichen rechteckförmiges Signal aus dem Ausgangssignal des Phasenregelkreises erzeugt. Die Phaseninformation bleibt dabei im Nulldurchgang des Rechtecksignals erhalten. Das Rechtecksignal wird an einen Eingang 41 eines Verstärkers 4 angelegt. Der Ausgang des Verstärkers 4 ist an eine Antenne 5 angeschlossen.

Das Amplitudenmodulationssignal r(kT), das an dem Eingang 11 angelegt wird, wird in ein Stromsignal gewandelt, das als Versorgungsstrom dem Verstärker 4 zugeführt wird. Dazu ist der Eingang 11 an einen ersten Eingang 871 einer Multiplikationseinheit 87 angeschlossen. Die Multiplikationseinheit 87 skaliert das Amplitudenmodulationssignal mit einem Skalierungsfaktor, der einem zweiten Eingang 872 zugeführt wird. Der Skalierungsfaktor dient zur Einstellung einer Gesamtamplitude und damit einer Gesamtleistung. Soll beispielsweise die Ausgangsleistung des Polarmodulators um 3dB steigen, so ist es zweckmäßig mit einer Skalierung des Amplitudenmodulationssignals die Ausgangsleistung zu ändern.

Die skalierte Amplitudeninformation dient zur Einstellung eines Versorgungsstroms einer regelbaren Stromquelle 3. Die regelbare Stromquelle 3 enthält einen Digital/Analogwandler 33, der aus dem digitalen und wertdiskreten Amplitudenmodulationssignal ein analoges Amplitudenmodulationssignal erzeugt. Dieses wird über ein Anti-Aliasing-Filter 34 einem Stelleingang 351 zugeführt. Das Anti-Aliasing-Filter 34 unterdrückt die höherwertigen Anteile im analogen Amplitudenmodulationssignal, die bei der Digital/Analog-Wandlung erzeugt werden. Der Stelleingang 35 ist mit dem Ausgang 32 der regelbaren Stromquelle 3 gekoppelt.

Das am Eingang 35 anliegende Stromsignal steuert den Versorgungsstrom am Ausgang 32 und damit den Versorgungsstrom des Verstärkers 4. Die Amplitudeninformation wird so in eine Modulation des Versorgungsstroms des Verstärkers 4 gewandelt. Durch die Modulation des Versorgungsstroms bleibt gleichzeitig ein ausreichend gutes Signal/Rauschverhältnis erhalten und die Versorgungsspannung des Verstärkers 4 kann in geeigneter Weise an die verwendete Fertigungstechnologie angepasst werden.

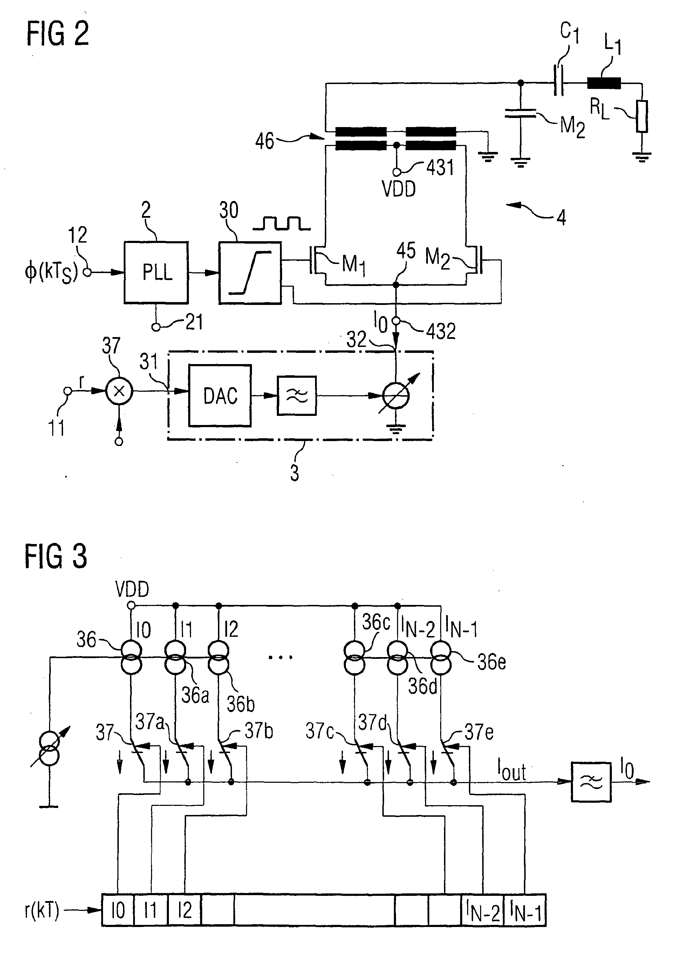

Figur 2 zeigt eine konkrete Ausführungsform des Verstärkers 4 zusammen mit weiteren Elementen des erfindungsgemäßen Polarmodulators. Wirkungs- und funktionsgleiche Bauelemente tragen die gleichen Bezugszeichen. Der Eingang 12 zur Zuführung des Phaseninformationssignals φ(kt) ist auch hier an den Phasenregelkreis 2 angeschlossen, der ausgangsseitig über den begrenzenden Verstärker 30 mit dem Verstärker 4 gekoppelt ist. Der Verstärker 4 ist als Differenzverstärker mit zwei Differenzverstärkertransistoren M₁ und M₂ ausgeführt. Dabei sind die Steueranschlüsse der beiden Differenzverstärkertransistoren M₁ und M₂ mit dem Ausgang des begrenzenden Verstärkers 30 verbunden. Die hier dargestellte Ausführungsform dient zur Verarbeitung von Gegentaktsignalen.

Die beiden Differenzverstärkertransistoren M₁ und M₂ sind mit jeweils einem ersten Anschluss in einem gemeinsamen Knoten 45 miteinander verbunden. Dieser Knoten 45 führt an einen ersten Teilversorgungsanschluss 432, der direkt an den Ausgang 32 der regelbaren Stromquelle 3 angeschlossen ist. Die jeweils zweiten Anschlüsse der Feldeffekttransistoren M₁ und M₂ sind über einen Teil eines transformatorischen Übertragers 46 miteinander verbunden.

Der transformatorische Übertrager 46 enthält einen Teilversorgungsanschluss 431 zur Versorgung mit einem Potenzial V_{DD}. Weiterhin ist der transformatorische Übertrager 46 an ein Anpassnetzwerk aus dem in Reihe geschalteten Kondensator C1 und der Spule L1 angeschlossen. Parallel dazu ist ein zweiter Kondensator C2 vorgesehen. Das Anpassnetzwerk dient zur Impedanzanpassung der Impedanzen des transformatorischen Übertragers 46 an eine extern angeschlossene Last R_{L}. Die hier schematisch dargestellte Last ist bevorzugt als Antenne ausgebildet sein.

Im Betrieb wird dem erfindungsgemäßen Polarmodulator an den Eingängen 11 und 12 ein Amplitudeninformationssignal r(kT) und ein Phasenmodulationssignal φ(kT) zugeführt. Die beiden Signale r(kT) und φ(kT) werden von der Koderschaltung 993 und der Schaltung 902 aus wertdiskreten Koeffizienten aₖ erzeugt.

Das Phasenmodulationssignal φ(kT) wird in dem Phasenregelkreis verarbeitet. Der Phasenregelkreis 2 erzeugt ein phasenbeziehungsweise frequenzmoduliertes Ausgangssignal und führt dieses dem begrenzenden Verstärker 30 zu, der daraus ein Rechtecksignal erzeugt. Gleichzeitig mit dem Phaseninformationssignal wird das Amplitudeninformationssignal mit einem Skalierungsfaktor durch die Multiplikationseinheit 87 beaufschlagt. Der Skalierungsfaktor bestimmt sich dabei aus einer gewünschten Gesamtausgangsleistung.

Anschließend wird das so skalierte Amplitudenmodulationssignal in einem Digital/Analogkonverter der Stromquelle 3 in ein entsprechend amplitudenmoduliertes Stromsignal gewandelt. Das nachgeschaltete Tiefpassfilter dient zur Unterdrückung höherfrequenter Anteile, die bei der Digital/Analogwandlung erzeugt werden. Es ist zweckmäßig, eine Signalverarbeitung und insbesondere eine Digital/Analogwandlung in einer reinen Stromsignalverarbeitung vorzusehen. Dadurch kann in geeigneter Weise ein sehr gutes Signal/Rauschverhältnis bei gleichzeitig geringen Versorgungsspannungen erreicht werden. Als Tiefpassfilter bietet sich ein Anti-Alliasing-Filter mit höherer Ordnung an. Ebenso ist es möglich, das Stromsignal einem Strom/Spannungswandler innerhalb der Filtereinrichtung zuzuführen, und einen Filtervorgang in der Spannungsdomäne vorzunehmen. Anschließend wird das gefilterte Spannungssignal wieder in ein Stromsignal gewandelt.

Figur 3 zeigt eine Ausführungsform eines Digtal/Analogwandlers, der in der Stromdomäne arbeitet und ein analoges Stromsignal Iₒᵤₜ abgibt. Der in Figur 3 dargestellte Wandler ist Teil der regelbaren Stromquelle. Er umfasst mehrere parallel angeordnete Teilstromquellen 36, 36a, 36b, 36c bis 36e die jeweils einen festen Strom I0, I1, I2, ..., IN-2, IN-1 bereitstellen. Ausgangsseitig sind die Stromquellen 36, 36a bis 36e mit Schaltvorrichtungen 37, 37a bis 37e verbunden. Diese schalten abhängig von dem Amplitudenmodulationssignal die jeweiligen Stromquellen auf den Ausgang des Digital/Analogwandlers.

Im vorliegenden Ausführungsbeispiel ist das digitale Amplitudenmodulationssignal überabgetastet. Eine Überabtastung eines digitalen Signals ermöglicht eine deutlich feinere Auflösung und damit eine bessere Quantisierung. Beispielsweise beträgt die Überabtastfrequenz 26 MHz bei einer Frequenz des Basisbandsignals von 270,83 KHz. Das Amplitudenmodulationssignal r(kT) wird somit 96-fach überabgetastet. Der vorliegende Digital/Analogwandler enthält demnach 96 parallel angeordnete Teilstromquellen 36.

Der von den Teilstromquellen bereitgestellte Strom kann für jede Teilstromquelle verschieden sein. Alternativ dazu gibt jede Teilstromquelle den gleichen Strom ab. Eine solche Ausführung besitzt den Vorteil, dass systematische Fehler beziehungsweise Fehler aufgrund von Bauteilschwankungen besser kompensiert werden können.

Als Ausführungsform einer Teilstromquelle bietet sich ein einfacher Stromspiegel an. Ein solcher Stromspiegel ist beispielsweise in der Figur 4 zu sehen, der gleichzeitig auch ein Ausführungsbeispiel des Schaltungsblocks 35 darstellt. Der Stromspiegel gemäß Figur 4 ist mit Bipolartransistoren sowie einem Kaskodebipolartransistor aufgebaut. Der Stromspiegel enthält einen ersten Transistor 332, dessen Steueranschluss mit seinem Kollektoranschluss und damit dem Stelleingang 35 verbunden ist. Der Emitteranschluss des Transistors 332,ist an die Masse geführt. Weiterhin ist ein Stromspiegeltransistor 333 vorgesehen, dessen Steueranschluss an den Steueranschluss des ersten Transistors 332 angeschlossen ist und dessen Kollektor mit dem Emitter eines Kaskodetransistors 335 verbunden ist. Der Kollektor des Kaskodetransistors bildet den Ausgang 32 des Schaltungsblocks 38. Mit diesem Stromspiegel wird ein am Eingang 35 angelegtes Stromsignal in den Ausgang 32 gespiegelt. Durch eine Modulation eines am Eingang 3 anliegenden Stromsignals wird so auch der Ausgangsstrom am Ausgang 32 moduliert.

Durch die Wahl unterschiedlicher Geometrieparameter in den Transistoren 332 und 333 ist es möglich, das Stromspiegelverhältnis zu verändern. Darüber hinaus bietet es sich an, mehrere Stromspiegeltransistoren 333 parallel anzuordnen, um so den Ausgangsstrom in Abhängigkeit der gewünschten Ausgangsleistung zu erhöhen. Die hier dargestellte Ausführungsform ist mit Bipolartransistoren realisiert. Ebenso können Feldeffekttransistoren implementiert werden.

Mit der Erfindung wird so ein Polarmodulator realisiert, der besonders einfach als integrierte Schaltung in einem Halbleiterkörper realisiert. Ein Mischer wird für eine Modulation des Signals nicht mehr berichtigt. Die Amplitudenmodulation erfolgt über die Modulation des Versorgungsstroms eines dem Phasenmodulator nachgeschalteten Verstärkers. Dadurch wird trotz kleiner Versorgungsspannungen ein gutes Signal-/Rauschverhältnis erzeugt.

### Bezugszeichenliste

- 2:: Phasenregelkreis
- 3:: regelbare Stromquelle
- 4:: Verstärker
- 6:: spannungsgesteuerter Oszillator
- 7:: Frequenzteiler
- 8:: Schleifenfilter
- 9:: Ladungspumpe
- 10:: Phasendetektor
- 11:: Amplitudeninformationseingang
- 12:: Phaseninformationseingang
- 5:: Antenne
- 21:: Stelleingang
- 22:: Sigma-Delta-Modulator
- 23:: Referenzeingang
- 23a:: Referenzsignalgenerator
- 231:: Rückführungseingang
- 24:: Knoten
- 61:: Stelleingang
- 41:: Signaleingang
- 30:: begrenzender Verstärker
- 42:: Signalausgang
- 43:: Stromversorgungseingang
- 32:: Stromversorgungsausgang
- 33:: Digital/Analogwandler
- 34:: Tiefpassfilter
- 38:: Schaltungsblock, Stromspiegel
- 35:: Steuereingang
- 36, 36a, ..., 36e:: Teilstromquellen
- 37, 37a, ..., 37e:: Schalter
- 31:: Stelleingang
- 87:: Multiplikationseinheit

- 871, 872:: Signaleingänge
- 431, 432:: Teilversorgungsanschlüsse
- 46:: transformatorische Übertrager
- C1, C2:: Kondensatoren
- L1:: Spule
- M₁, M₂: Transistoren

## Patentansprüche

1. Polarmodulator, umfassend:
- einen ersten Signaleingang (12) zur Zuführung eines Phasenmodulationssignals (φ) und einen zweiten Signaleingang (11) zur Zuführung eines Amplitudenmodulationssignals (r);
- einen Phasenregelkreis (2) mit einem Referenzeingang (23) zur Zuführung eines Referenzsignals und mit einem Stelleingang (21), der mit dem ersten Signaleingang (12) gekoppelt ist, der Phasenregelkreis (2) ausgebildet zur Abgabe eines Hochfrequenzsignals mit einer Frequenz an einen Ausgang, wobei die Frequenz aus dem Referenzsignal und dem Phasenmodulationssignals (φ) am Stelleingang (21) des Phasenregelkreises (2) abgeleitet ist;
- eine regelbare Stromquelle (3) mit einem Regeleingang (31), der mit dem zweiten Signaleingang (11) gekoppelt ist, die Stromquelle (3) ausgebildet zur Abgabe eines von dem Amplitudenmodulationssignal (r) am Regeleingang (31) abhängigen Stroms an einen Ausgang (32);
- einen Verstärker (4) mit einem Signaleingang (41) zur Zuführung eines zu verstärkenden Signals, der mit dem Ausgang des Phasenregelkreises (2) gekoppelt ist, mit einem Signalausgang (42), der einen Ausgang des Polarmodulators bildet und mit einem Versorgungsanschluss (43) zur Zuführung eines Versorgungsstroms, der an den Ausgang (32) der regelbaren Stromquelle (3) angeschlossen ist.

2. Polarmodulator nach Anspruch 1,
bei dem zwischen Ausgang des Phasenregelkreises (2) und dem Signaleingang des Verstärkers (4) eine Verstärkerschaltung (30) vorgesehen ist, die ein begrenzendes Verstärkungsverhalten aufweist.

3. Polarmodulator nach einem der Ansprüche 1 bis 2,
bei dem der Verstärker (4) einen ersten Teilanschluss (431) umfasst, der zur Zuführung eines Versorgungspotentials (V_{DD}) ausgeführt ist, und der einen zweiten Teilanschluss (432) umfasst, der mit dem Ausgang (32) der regelbaren Stromquelle (3) verbunden ist.

4. Polarmodulator nach einem der Ansprüche 1 bis 3,
bei dem der Verstärker (4) mit einem Differenzverstärker ausgeführt ist, der einen ersten Transistor (M1) und einen zweiten Transistor (M₂) umfasst, wobei Steueranschlüsse der Transistoren (M₁, M₂) den Signaleingang des Verstärkers (4) bilden, und jeweils ein erster Anschluss des ersten und zweiten Transistors in einem Knoten (45) miteinander verbunden sind, der den Versorgungsanschluss bildet.

5. Polarmodulator nach einem der Ansprüche 1 bis 4,
bei dem der Verstärker (4) mit Feldeffekttransistoren ausgeführt ist.

6. Polarmodulator nach einem der Ansprüche 1 bis 5,
bei dem der Verstärker (4) einen transformatorischen Übertrager (46) umfasst, der zur Transformation eines Gegentaktsignals in ein Eintaktsignal ausgeführt ist.

7. Polarmodulator nach einem der Ansprüche 1 bis 6,
bei dem der Phasenregelkreis (2) einen Frequenzteiler (7) in einem Rückführungspfad (28) umfasst, der ausgebildet ist, ein eingangsseitig anliegendes Signal in seiner Frequenz um einen einstellbaren Teilerfaktor zu teilen, und der einen mit dem ersten Signaleingang (12) verbundenen Einstelleingang zur Einstellung des Teilerfaktors aufweist.

8. Polarmodulator nach Anspruch 7,
bei dem dem Einstelleingang des Frequenzteilers (7) ein Sigma-Delta-Frequenzteiler (22) vorgeschaltet ist, der eingangsseitig mit dem ersten Signaleingang gekoppelt ist.

9. Polarmodulator nach einem der Ansprüche 1 bis 8,
bei dem der Phasenregelkreis (2) mit einem 2-Punkt-Modulator ausgebildet ist.

10. Polarmodulator nach einem der Ansprüche 1 bis 9,
bei dem die regelbare Stromquelle (3) einen Stromspiegel (38) mit einem ersten und einem zweiten steuerseitig gekoppelten Transistor aufweist, wobei ein Ausgang des zweiten Transistors den Ausgang (32) der Stromquelle (3) bildet und dem ersten Transistor ein von dem Amplitudenmodulationssignal (r) abgeleiteter Referenzstrom zuführbar ist.

11. Polarmodulator nach einem der Ansprüche 1 bis 10,
bei dem die regelbare Stromquelle (3) einen Digital/Analog-Wandler (33) umfasst, dessen Eingang an den Regeleingang (31) angeschlossen ist und der ein eingangsseitig zugeführtes wertdiskretes Signal in ein Stromsignal wandelt.

12. Polarmodulator nach Anspruch 11,
bei dem zwischen Digital/Analog-Wandler (33) und Ausgang der regelbaren Stromquelle (3) ein Tiefpassfilter (34) geschaltet ist.

13. Polarmodulator nach einem der Ansprüche 1 bis 12,
bei dem die regelbare Stromquelle (3) eine Vielzahl an Teilstromquellen (36, 36a, 36b, 36c, 36d, 36e) umfasst, deren Ausgänge jeweils über eine, durch ein Signal am Regeleingang (31) steuerbare Schaltvorrichtung (37, 37a, 37b, 37c, 37d, 37e) auf den Ausgang (32) der regelbaren Stromquelle (3) schaltbar sind.

14. Polarmodulator nach Anspruch 13,
bei dem zumindest eine der Vielzahl an Teilstromquellen (36, 36a, 36b, 36c, 36d, 36e) zur Erzeugung zumindest zweier einstellbarer verschieden großer Teilströme ausgeführt ist.

15. Polarmodulator nach einem der Ansprüche 13 bis 14,
bei dem eine erste Teilstromquelle (36) der Vielzahl an Teilstromquellen zur Erzeugung eines Teilstromes (I0) ausgeführt ist, der sich von einem Teilstrom (I1) einer zweiten Teilstromquelle (36a) um einen Faktor 2 unterscheidet.

16. Polarmodulator nach einem der Ansprüche 1 bis 15,
bei dem dem Regeleingang (31) der Stromquelle (3) eine Multiplikationseinheit (87) vorgeschaltet ist, die zur Skalierung des Amplitudenmodulationssignals an einem ersten Eingang (871) der Multiplikationseinheit (81) mit einem Skalierungsfaktor ausgebildet ist, der einem zweiten Eingang (872) zuführbar ist.

17. Verfahren zur Modulation eines Signals, umfassend die Schritte:
- Bereitstellen eines Phasenregelkreises (2) mit einem einstellbaren Frequenzteilerverhältnis in einem Rückführungspfad (28) des Phasenregelkreises (2);
- Bereitstellen eines Verstärkers (4) und Koppeln des Verstärkers (4) mit einem Ausgang des Phasenregelkreises (2);
- Bereitstellen eines Phasenmodulationssignals (φ) und eines Amplitudenmodulationssignals (r) für eine Signalmodulation;
- Zuführen des Phasenmodulationssignals (φ) an den Phasenregelkreis (2) und Einstellen des Frequenzteilerverhältnisses in Abhängigkeit des Phasenmodulationssignals (φ);
- Erzeugen eines phasenmodulierten Signals in Abhängigkeit des eingestellten Frequenzteilerverhältnisses;
- Erzeugen eines Stromsignals aus dem Amplitudenmodulationssignals (r);
- Zuführen des phasenmodulierten Signals an den Verstärker (4) bei gleichzeitigem Versorgen des Verstärkers (4) mit einem von dem Stromsignal abgeleiteten Versorgungsstroms.

18. Verfahren nach Anspruch 17,
bei dem der Schritt des Erzeugens eines Stromsignals die Schritte umfasst:
- Skalieren des Amplitudenmodulationssignals mit einem Faktor;
- Erzeugen eines wertkontinuierlichen Stromsignals aus dem skalierten Amplitudenmodulationssignal.
